(19) **Europäisches Patentamt**

**European Patent Office**

**Office européen des brevets**

(11) **EP 1 011 147 A2**

(12) **EUROPEAN PATENT APPLICATION**

(43) Date of publication:
**21.06.2000 Bulletin 2000/25**

(51) Int. Cl.$^7$: **H01L 29/737**, H01L 29/812,
H01L 29/78, H01L 29/15

(21) Application number: **99125100.0**

(22) Date of filing: **16.12.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **16.12.1998 JP 35742998**

(71) Applicant:
**Canare Electric Co., Ltd.
Aichi-gun, Aichi-ken 480-1101 (JP)**

(72) Inventor: **Kano, Hiroyuki
Nishikamo-gun, Aichi-ken, 470-0201 (JP)**

(74) Representative:
**Pellmann, Hans-Bernd, Dipl.-Ing. et al
Patentanwaltsbüro
Tiedtke-Bühling-Kinne & Partner
Bavariaring 4-6
80336 München (DE)**

(54) **Transistors having a quantum-wave interference layer**

(57)    A transistor having an electron quantum-wave interference layer with plural periods of a pair of a first layer W and a second layer B in a p-layer of an npn junction structure. The second layer B has wider band gap than the first layer W. Each thicknesses of the first layer W and the second layer B is determined by multiplying by an even number one fourth of quantum-wave wavelength of carriers in each of the first layer W and the second layer B, the carriers existing around the lowest energy level of the second layer B. The quantum-wave interference layer functions as an electron transmitting layer, and enables to lower a dynamic resistance of the transistor notably. A performance characteristics of a MESFET of an npn junction structure, having the electron transmitting layer is improved compared with a MESFET without an electrode transmitting layer. Similarly, a transistor having a hole reflecting layer, which has an improved performance characteristics, can be obtained. Forming a hole reflecting layer can be applied to a bipolar transistor or a MOSFET.

# F I G. 1

EP 1 011 147 A2

**Description**

BACKGROUND OF THE INVENTION

Field of the invention

The present invention relates to a transistor having a new junction structure with whose dynamic resistance is lowered.

Description of the Related Art

Bipolar transistors which has a pnp or an npn junction structure have been known. Electric current, which flows when the forward voltage is applied to the transistor having a pn junction structure, increases rapidly at the point where the forward voltage exceeds the potential difference between the conduction bands of p and n layers. The larger gradient of the characteristic carve between electric current and voltage in the dynamic range is, the more suitable the transistor becomes to use as various devices.

However, a problem persists in the gradient. The gradient of electric current and voltage characteristics could not be varied because it is determined by materials which form the transistor. Therefore, further improvement has been required, as presently appreciated by the present inventors. And a unipolar transistor similar to a field effect transistor has been known.

As a countermeasure, reflecting carriers by forming cladding layers with a multi-quantum well structure of a first and a second layers as a unit in a laser diode (LD) has been suggested by Takagi et al. (Japanese Journal of Applied Physics. Vol.29, No.11, November 1990, pp.L1977-L1980). Although it can be led that a band gap energy is used as an alternative of a kinetic energy, this reference does not teach or suggest values of kinetic energy of carriers to be considered and the degree of luminous intensity improvement is inadequate.

SUMMARY OF THE INVENTION

The inventor of the present invention conducted a series of experiments and found that the suggested thicknesses of the first and the second layers by Takagi et al. were too small to reflect carriers, and that preferable thicknesses of the first and second layers are 4 to 6 times larger than those suggested by Takagi et al. Further, the present inventors thought that multiple reflection of quantum-waves of carriers might occur by a multi-layer structure with different band width, like multiple reflection of light by a dielectric multi-film structure. And the inventors thought that it would be possible to vary the I-V characteristic of carriers when the external voltage is applied to the device by the quantum-wave reflection. As a result, the inventors invented a preferable quantum-wave interference layer and applications of the same.

Then the inventor of the present invention concerned a characteristic of electron as a wave and considered that the quantum-wave interference layer functions as a transmission layer of carriers, by analogy with the multiple reflection of the light. That is, when each thickness of layers in the multi-layer structure is about an order of the wavelength of a quantum-wave of carriers, an interference effect of quantum-wave is considered to be occurred with respect to a conduction of carriers in the multi-layer structure. The interference effect caused a conduction as a wave. Accordingly, the inventors of the present invention considered that not a conduction of particle in a classical theory but a resonance of waves, an interference, or other phenomenon is occurred by an interference effect of electrons. This wave behavioral characteristic of electrons improves a mobility and a propagation velocity.

And the inventor thought that it would be possible to vary I-V characteristic of carriers at which a current starts to flow by the transmission. As a result, the inventors invented a preferable quantum-wave interference layer and applications of the same.

It is, therefore, an object of the present invention to provide a transistor having a junction structure with considerably lower dynamic resistance by forming a quantum-wave interference layer. Another object of the present invention is to provide a transistor having a high responsibility.

In light of these objects a first aspect of the present invention is a transistor constituted by forming a quantum-wave interference layer having plural periods of a pair of a first layer and a second layer in a base region or a channel region, the second layer having a wider band gap than the first layer. Each thickness of the first and the second layers is determined by multiplying by an even number one fourth of quantum-wave wavelength of injected minority carriers in each of the first and the second layers.

The second aspect of the present invention is a transistor constituted by a quantum-wave interference layer having plural periods of a pair of a first layer and a second layer in a base region or a channel region. The second layer has a wider band gap than the first layer. A δ layer is included for sharply varying energy band and is formed between the first and the second layers. Each thickness of the first and the second layers is determined by multiplying by even number one fourth of quantum-wave wavelength of injected minority carriers in each of the first and the second layers, and a thickness of the δ layer is substantially thinner than that of the first and the second layers.

The third aspect of the present invention is a transistor having injected carriers existing around the lowest energy level of the second layer.

The fourth aspect of the present invention is to define each thickness of the first and the second layers as follows:

$$D_W = n_W \lambda_W /4 = n_W h/4[2m_W(E+V)]^{1/2} \tag{1}$$

and

$$D_B = n_B \lambda_B /4 = n_B h/4(2m_B E)^{1/2} \tag{2}$$

In Eqs. 1 and 2, h, $m_W$, $m_B$, E, V, and $n_W$, $n_B$ represent a Plank's constant, effective mass of minority carriers injected into the first layer, effective mass of minority carriers in the second layer, kinetic energy of minority carriers injected into the second layer, potential energy of the second layer to the first layer, and even numbers, respectively. An minority carriers injected into the second layer are preferably existing around the lowest energy level of the second layer.

The fifth aspect of the present invention is a transistor having a plurality of partial quantum-wave interference layers $I_k$ in a base region or a channel region with arbitrary periods $T_k$ including a first layer having a thickness of $D_{Wk}$ and a second layer having a thickness of $D_{Bk}$ and arranged in series. The thicknesses of the first and the second layers satisfy the formulas:

$$D_{Wk} = n_{Wk} \lambda_{Wk} /4 = n_{Wk} h/4[2m_{Wk}(E_k+V)]^{1/2} \tag{3}$$

and

$$D_{Bk} = n_{Bk} \lambda_{Bk} /4 = n_{Bk} h/4(2m_{Bk} E_k)^{1/2} \tag{4}$$

In Eqs. 3 and 4, $E_k$, $m_{Wk}$, $m_{Bk}$, and $n_{Wk}$ and $n_{Bk}$ represent plural kinetic energy levels of minority carriers injected into the second layer, effective mass of minority carriers with kinetic energy $E_k+V$ in the first layer, effective mass of minority carriers with kinetic energy $E_k$ in the second layer, and arbitrary even numbers, respectively.

The plurality of the partial quantum-wave interference layers $I_k$ are arranged in series from $I_1$ to $I_j$, where j is a maximum number of k required to form a quantum-wave interference layer as a whole.

The sixth aspect of the present invention is a transistor having a quantum-wave interference layer with a plurality of partial quantum-wave interference layers arranged in series with arbitrary periods. Each of the plurality of partial quantum-wave interference layers is constructed with serial pairs of the first and second layers. The widths of the first and second layers of the serial pairs are represented by $(D_{W1}, D_{B1})$, ..., $(D_{Wk}, D_{Bk})$, $(D_{Wj}, D_{Bj})$. $(D_{Wk}, D_{Bk})$ is a pair of widths of the first and second layers and is defined as Eqs. 3 and 4, respectively.

The seventh aspect of the present invention is to determine thickness of each quantum-wave interference layers according to a quantum-wave wavelength of carrier which conducts at a certain threshold of applied electric field.

The eighth aspect of the present invention is to form a δ layer between a first layer and a second layer which sharply varies the energy band and has a thickness substantially thinner than that of the first and the second layers.

The ninth aspect of the present invention is to constitute a quantum-wave incident facet in the quantum-wave interference layer by a second layer with enough thickness for preventing conduction of minority carriers injected into the first layer by a tunneling effect.

The tenth aspect of the present invention is a bipolar transistor having the quantum-wave interference layer in a base region.

The eleventh aspect of the present invention is a field effect transistor having the quantum-wave interference layer in a channel region.

(first, third and fourth aspects of the present invention)

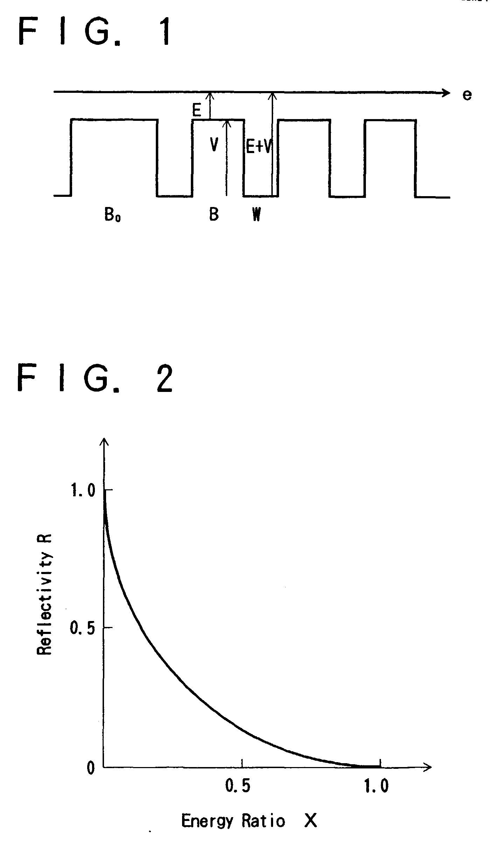

The principle of the quantum-wave interference layer of the present invention is explained hereinafter. FIG. 1 shows a conduction band of a multi-layer structure, i.e., in a base or channel area, with plural periods of a pair of a first layer W and a second layer B. A band gap of the second layer B is wider than that of the first layer W. Electrons conduct from left to right as shown by an arrow in FIG. 1. Among the electrons, those that existing around the bottom of the second layer B are likely to contribute to conduction. The electrons around the bottom of the second layer B has a kinetic energy E. Accordingly, the electrons in the first layer W have a kinetic energy E+V which is accelerated by potential energy V due to the band gap between the first layer W and the second layer B. In other words, electrons that move from the first layer W to the second layer B are decelerated by potential energy V and return to the original kinetic energy E in the second layer B. As explained above, kinetic energy of electrons in the conduction band is modulated by potential energy due to the multi-layer structure. When thickness of the first layer W and the second layer B are equal to order of a quantum-wave wavelength, electrons tend to have characteristics of a wave. The wave length of the electron quantum-wave is calculated by Eqs. 1 and 2 using kinetic energy of the electron. Further, defining the respective wave number vector in first layer W and second layer B as $K_W$ and $K_B$, reflectivity R of the wave is calculated by:

$$R = (|K_W|-|K_B|) / (|K_W|+|K_B|) \qquad (5).$$
$$= [\{m_W(E+V)\}^{1/2}-[m_B E]^{1/2}) / [\{m_W(E+V)\}^{1/2}+(m_B E)^{1/2}]$$
$$= [1-\{m_B E/m_W(E+V)\}^{1/2}] / [1+\{m_B E/m_W(E+V)\}^{1/2}]$$

Further, when $m_B = m_W$, the reflectivity R is calculated by:

$$R = [1-\{E/(E+V)\}^{1/2}] / [1+\{E/(E+V)\}^{1/2}] \qquad (6).$$

When $E/(E+V) = x$, Eq. 6 is transformed into: $R = (1-x^{1/2}) / (1+x^{1/2})$ (7).

The characteristic of the reflectivity R with respect to energy ratio x obtained by Eq. 7 is shown in FIG. 2.

When the formula $x \leqq 1/10$ is satisfied, $R \cong 0.52$. Accordingly, the relation between E and V is satisfied with:

$$E \leqq V/9 \qquad (8)$$

Since the kinetic energy E of conducting electrons in the second layer B exists around the bottom of the conduction band, the relation of Eq. 8 is satisfied and the reflectivity R at the interface between the second layer B and the first layer W becomes 52 % or more. Consequently, the multi-quantum well structure having two kinds of layers with different band gaps to each other enables to reflect quantum-wave of electrons between the first and the second layers.

Further, utilizing the energy ratio x enables thickness ratio $D_B/D_W$ of the second layer B to the first layer W to be obtained by:

$$D_B/D_W = [m_W / (m_B x)]^{1/2} \qquad (9).$$

When thicknesses of the first and second layers are determined by multiplying an even number by one fourth of a quantum-wave wavelength, or by a half of a quantum-wave wavelength, for example, a standing wave rises in a quantum-wave interference layer, and a resonant conduction is occurred. That is, when a quantum-wave period of the standing wave and a potential period of the quantum-wave interference layer is corresponded to each other, a scattering of the carrier in each layer is suppressed, and a conduction of a high mobility is realized.

Thicknesses of the first layer W and the second layer B are determined for selectively transmitting one of holes and electrons, because of a difference in potential energy between the valence and the conduction bands, and a difference in effective mass of holes and electrons in the first layer W and the second layer B. Namely, the optimum thickness of the first and the second layers for transmitting electrons is not optimum for transmitting holes. Eqs. 5-9 refer to a structure of the quantum-wave interference layer for transmitting electrons selectively. The thickness for selectively transmitting electrons is designed based on a difference in potential energy of the conduction band and effective mass of electrons. Consequently, the quantum-wave interference layer has a high transmttivity (or a high mobility) for electrons, but not for holes.

Further, the thickness for selectively transmitting holes is designed based on a difference in potential energy of the valence band and effective mass of holes, realizing another type of quantum-wave interference layer as a hole transmission layer, which has a high mobility for holes and which has an ordinary mobility for electrons.

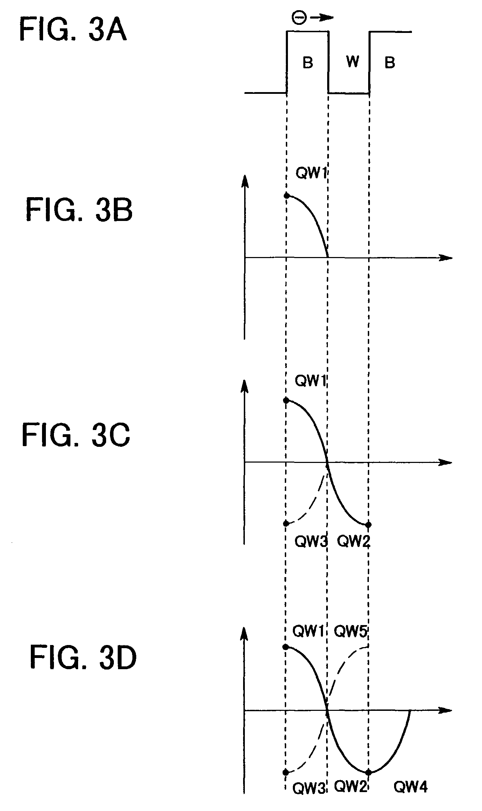

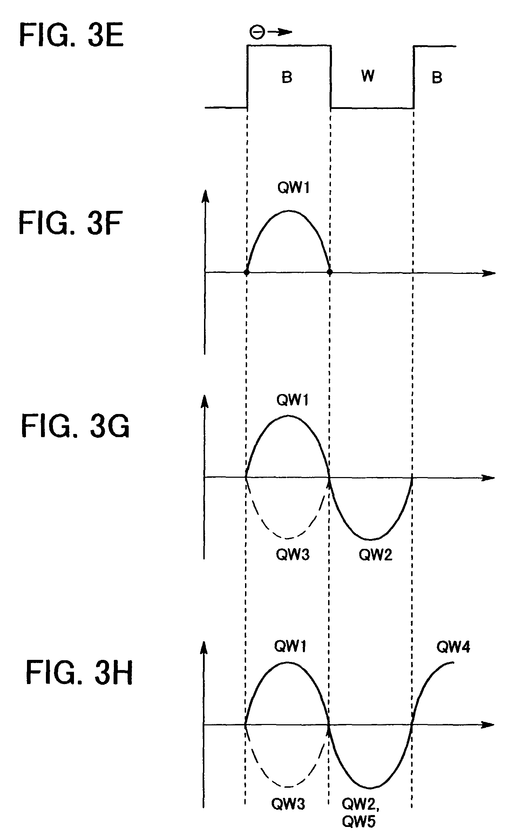

Further explanation can be obtained by FIGS. 3A-3H. FIGS. 3A-3H illustrate the relationship between quantum-wave reflection of electrons in a potential of quantum-well structure and a period of potential representing a conduction band of a multi quantum-well (MQW). FIGS. 3A-3D show the relationship when the period, i.e., width of the second layer B or the first layer W, of the potential is equal to an odd number multiplied by one fourth of the wavelength of propagated electron. This type of the potential is named as $\lambda/4$ type potential hereinafter. FIGS. 3E-3H show when the period of the potential is equal to a natural number multiplied by a half of the wavelength of propagated electron. This type of the potential is named as $\lambda/2$ type potential hereinafter. In order to make it visually intelligible, thickness of each layers is unified in FIGS. 3A-3H. Electrons existing around the bottom of the second layer B conduct from left to right as shown by an arrow in FIGS. 3A and 3E. And in FIGS. 3B and 3F, the electrons reach the interface between the first layer W and the second layer B.

When the quantum-wave of the electrons reaches the interface between the second layer B and the first layer W in the $\lambda/4$ type potential, a transmission wave QW2 and a reflection wave QW3 having a phase equal to that of the transmission wave QW2, are generated with respect to an incident wave QW1 as shown in FIG. 3C. Then when the transmission wave QW2 reaches the interface between the first layer W and the second layer B, a transmission wave QW4 and a reflection wave QW5 having a phase opposite to that of the transmission wave QW4 are generated as shown in FIG. 3D. The relationship between phases of the transmission wave and the reflection wave at the interface depends on following or rising of a potential of the conduction band at the interface. In order to make it visually intelligible, each amplitudes of QW1, QW2, QW3, QW4, and QW5 is unified in FIGS. 3A-3H.

With respect to the $\lambda/4$ type potential of the multi quantum-well, the propagating quantum-wave of electrons represented by QW1, QW2 and QW4 and the reflecting quantum-wave of electrons represented by QW3 and QW5 cancels with each other, as shown in FIG. 3D. The quantum-wave of electrons represented by the QW1, QW2 and QW4 propagates from left to right, and the quantum-wave of electrons represented by the QW3 and QW5, generated by the reflection at two interfaces, propagates from right to left. Accordingly, a multi quantum-well, having a potential which is formed in a period, i.e., the width of the first layer W and the second layer B, determined by multiplying by an odd number one fourth of quantum-wave wavelength of propagated electrons, cancels the quantum-wave of electrons. In short, the multi quantum-well functions as a reflection layer which does not propagate electrons.

With respect to a multi quantum-well, having a potential which is formed in a period, i.e., the width of the first layer W and the second layer B, determined by multiplying by an even number one fourth of quantum-wave wavelength of propagated electrons, i.e., $\lambda/2$ type potential, as shown in FIGS. 3E-3H, the quantum-wave of electrons can become a standing wave.

Similarly, when a quantum-wave of electrons reaches the interface between the second layer B and the first layer W in the $\lambda/2$ type potential, a transmission wave QW2 and a reflection wave QW3 having a phase corresponding to that of the transmission wave QW2, are generated with respect to an incident wave QW1 as shown in FIG. 3G. Then when the transmission wave QW2 reaches the interface between the first layer W and the second layer B, a transmission wave QW4 and a reflection wave QW5 having a phase opposite to that of the transmission wave QW4 are generated as shown in FIG. 3H. With respect to $\lambda/2$ type potential of the multi quantum-well, the propagating quantum-wave of electrons represented by QW1, QW2 and QW4 and the reflecting quantum-wave of electrons represented by QW5 intensifies to each other, as shown in FIG. 3H. On the other hand, the reflection waves QW3 and QW5 can be considered to cancel with each other and the quantum-wave of electrons which is propagated from left to right in FIG. 3E can be a standing wave. Accordingly, with respect to the multi quantum-well, having a potential which is formed in a period, i.e., the width of the first layer W and the second layer B, determined by multiplying by an even number one fourth of quantum-wave wavelength of propagated electrons, the quantum-wave of electrons can become a standing wave and a transmission layer having a high transmittivity (or a high mobility) for electrons can be realized.

Alternatively, a multi quantum-well, having a potential which is formed in a period determined by multiplying by a natural number half of quantum-wave wavelength of holes, can be applied to the relationship described above.

Forming a transmission layer, which has a high transmittivity (or a high mobility) for carriers, in a base region or a channel region of the transistor enables to lower its dynamic resistance and raise its cut-off frequency which proportions to mobility of carriers. Accordingly, the transistor of the present invention having a new junction structure has a remarkably excellent functions compared with a conventional transistor.

(fifth aspect of the present invention)

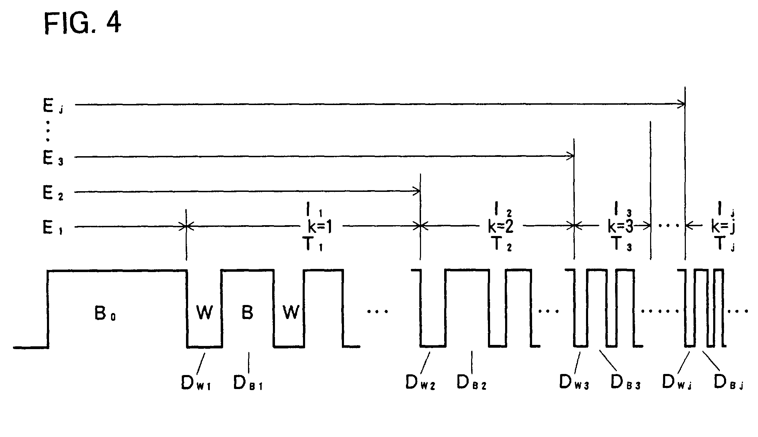

As shown in FIG. 4, a plurality of partial quantum-wave interference layers $I_k$ may be formed corresponding to each of a plurality of kinetic energy levels $E_k$. Each of the partial quantum-wave interference layers $I_k$ has $T_k$ periods of a pair of a first layer W and a second layer B whose respective thicknesses ($D_{Wk}$, $D_{Bk}$) are determined by Eqs. 3 and 4. The plurality of the partial quantum-wave interference layer $I_k$ is arranged in series with respect to the number k of kinetic energy levels $E_k$. That is, the quantum-wave interference layer is formed by a serial connection of $I_1$, $I_2$, ..., and $I_j$. As shown in FIG. 4, electrons with each of the kinetic energy levels $E_k$ are highly transmitted or conducted by the corresponding partial quantum-wave interference layers $I_k$. Accordingly, electrons belonging to each of the kinetic energy levels from $E_1$ to $E_j$ are reflected effectively. By designing the intervals between the kinetic energies to be short, thicknesses of the first layer W and the second layer B ($D_{Wk}$, $D_{Bk}$) in each of the partial quantum-wave interference layers $I_k$ vary continuously with respect to the value k.

(sixth aspect of the present invention)

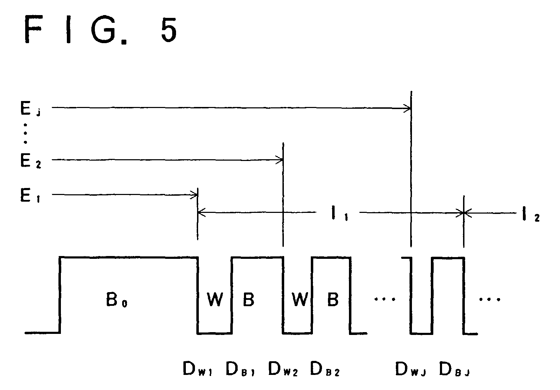

As shown in FIG. 5, a plurality of partial quantum-wave interference layers may be formed with an arbitrary period. Each of the partial quantum-wave interference layers, $I_1$, $I_2$, ... is made of serial pairs of the first layer W and the second layer B with widths ($D_{Wk}$, $D_{Bk}$) determined by Eqs. 3 and 4. That is, the partial quantum-wave interference layer, e.g., $I_1$, is constructed with serial layers of width ($D_{W1}$, $D_{B1}$), ($D_{W2}$, $D_{B2}$), .., ($D_{Wj}$, $D_{Bj}$), as shown. A plurality $I_1$, $I_2$, ... of layers such as layer $I_1$ are connected in series to form the total quantum-wave interference layer. Accordingly, electrons of the plurality of kinetic energy levels $E_k$ are effectively transmitted or conducted by each pair of layers in each partial quantum-wave interference layers. By designing the intervals between kinetic energies to be short, thicknesses of the pair of the first layer W and the second layer B ($D_{Wk}$, $D_{Bk}$) in a certain partial quantum-wave interference layer varies continuously with respect to the value k.

(seventh aspect of the present invention)

The seventh aspect of the present invention is to determine thickness of each quantum-wave interference layers according to a quantum-wave wavelength of carrier which conducts at a certain threshold of applied electric field.

(second and eighth aspects of the present invention)

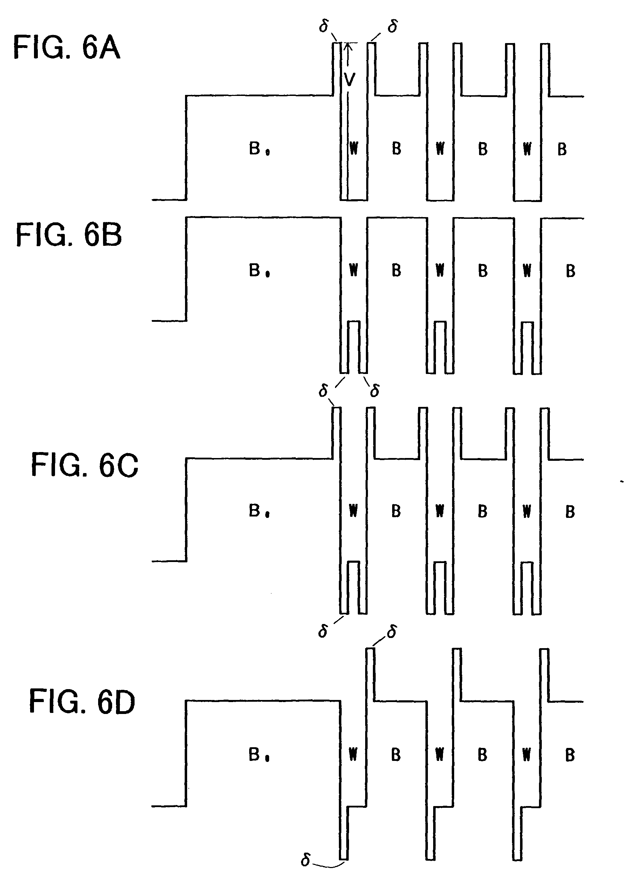

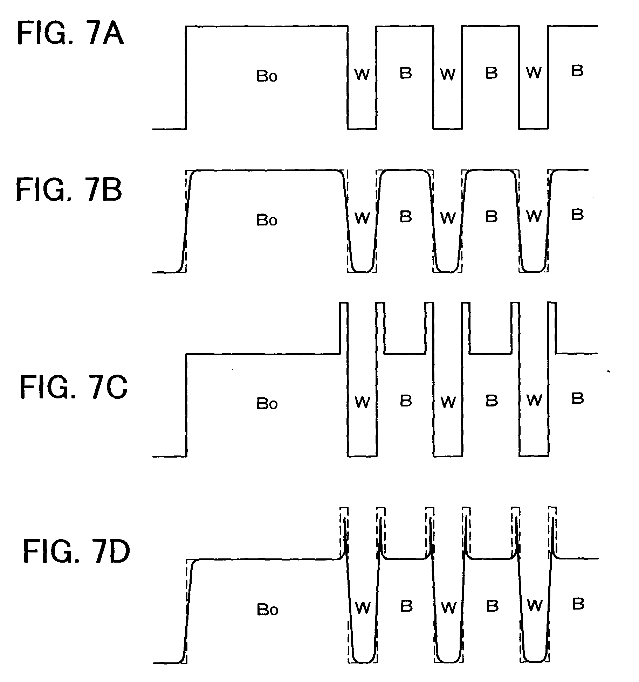

The second and the eighth aspects of the present invention are directed forming a δ layer at the interface between the first layer W and the second layer B. The δ layer has a relatively thinner thickness than both of the first layer W and the second layer B and sharply varies an energy band. By sharply varying the band gap of the interfaces, the potential energy V of an energy band becomes larger substantially and the value x of Eq. 7 becomes smaller, as shown in FIGS. 7A-7D. Without forming a δ layer as shown in FIG. 7A, a part of component of the first layer W and the second layer B mixes when the second layer B is laminated on the first layer W, and an energy band gap which varies sharply cannot be obtained, as shown in FIG. 7B. When a δ layer is formed at each interfaces of the first and the second layers, as shown in FIG. 7C, even if a part of component of the first layer W and the second layer B mixes, an energy band gap varies sharply compared with the case without δ layers, as shown in FIG. 7D.
Variations are shown in FIGS. 6A to 6D. The δ layer may be formed on both ends of the every first layer W as shown in FIGS. 6A to 6D. In FIG. 5A, the δ layers are formed so that an energy level higher than that of the second layer B may be formed. In FIG. 6B, the δ layers are formed so that a band having lower bottom than that of the first layer W may be formed. In FIG. 6C, the δ layers are formed so that the energy level higher than that of the second layer B and the energy level lower than that of the first layer W may be formed. As an alternative to the variation shown in FIG. 6C, the δ layer can be formed on one end every layer as shown in FIG. 6D.

(ninth aspect of the present invention)

The ninth aspect of the present invention, or forming a thick second layer $B_0$ at the side of an incident plane of the quantum-wave interference layer, and effectively prevents conduction by tunneling effects and reflects carriers.

(tenth and eleventh aspects of the present invention)

As described above, by forming a quantum-wave interference layer as an electron transmission layer, I-V characteristic varies sharply. And by applying the range of its I-V characteristic which varies sharply to a base voltage and a collector current of a bipolar transistor or a gate voltage and a drain current of a field effect transistor, a transistor having a larger amplification factor than that of a conventional transistor can be obtained.
And by forming a quantum-wave interference layer as a hole transmission layer, I-V characteristic varies sharply. Also, by applying the range of its I-V characteristic which varies sharply to a base voltage and a collector current of a bipolar transistor or a gate voltage and a drain current of a field effect transistor, a transistor having a larger amplification factor than that of a conventional transistor can be obtained.

BRIEF DESCRIPTION OF THE DRAWINGS

Other objects, features, and characteristics of the present invention will become apparent upon consideration of the following description and the appended claims with reference to the accompanying drawings, all of which form a part of the specification, and wherein reference numerals designate corresponding parts in the various figures, wherein:

FIG. 1 is an explanatory view of a conduction band of a multi-layer structure according to the first, third, and fourth aspects of the present invention;

FIGS. 2 is a graph showing a relation between an energy ratio x and a reflectivity R;

FIGS. 3A-3H are views of a relationship between quantum-wave reflection of electrons in a potential of quantum-well structure and a period of potential representing a conduction band of a multi quantum-well (MQW);

FIG. 4 is an explanatory view of partial quantum-wave interference layers $I_k$ according to the fifth aspect of the present invention;

FIG. 5 is an explanatory view of partial quantum-wave interference layers $I_k$ according to the sixth aspect of the present invention;

FIGS. 6A-6D are explanatory views of δ layers according to the second and eighth aspects of the present invention;

FIGS. 7A-7D are views showing energy level according to the second and eighth aspects of the present invention;

FIG. 8 is a sectional view showing a first exemplary structure of an nin junction device 100 (Example 1);

FIG. 9 is a view showing a measured V-I characteristic of a first exemplary semiconductor device (Example 1);

FIG. 10 is a view showing a measured V-I characteristic of a semiconductor device, in which the first layer W and the second layer B have a thickness of 1/4 wave length of a quantum wave, as a comparative example;

FIG. 11 is a sectional view showing a structure of an npn junction structure bipolar transistor 300 (Example 1);

FIG. 12 is a sectional view showing a structure of a field effect transistor 400 (Example 2);

FIGS. 13A-13C are views showing a method for manufacturing the field effect transistor of Example 2; and

FIG. 14 is a sectional view showing a structure of a field effect transistor 500 (Example 3).

## DETAILED DESCRIPTION OF THE PREFERRED EMBODIMENTS

The invention will be more fully understood by reference to the following examples.

Example 1

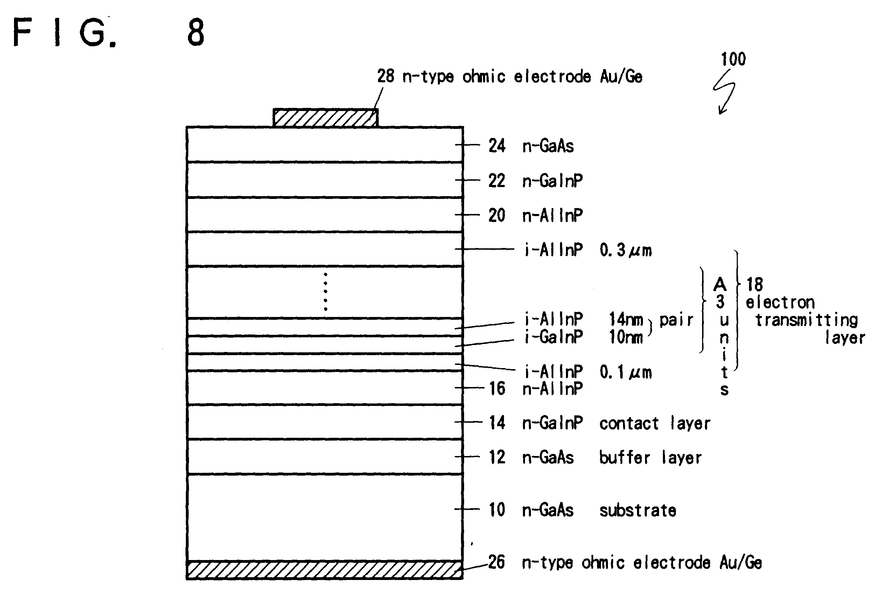

FIG. 8 is a sectional view of an nin junction semiconductor device 100 in which a quantum-wave interference layer is formed in an i-layer. The device 100 has a substrate 10 made of gallium arsenide (GaAs). An n-GaAs buffer layer 12 having a thickness generally of 0.3 μm and an electron concentration of 2 x $10^{18}$/cm$^3$ is formed on the substrate 10. An n-Ga$_{0.51}$In$_{0.49}$P contact layer 14 of n-type conduction, having a thickness generally of 0.13 μm and electron concentration of 2 x $10^{18}$/cm$^3$, is formed on the buffer layer 12. An n-Al$_{0.51}$In$_{0.49}$P cladding layer 16, having a thickness generally of 0.2 μm and an electron concentration of 1 x $10^{18}$/cm$^3$, is formed on the n-contact layer 14. An non-doped i-layer 18 is formed on the n-layer 16. An Al$_{0.51}$In$_{0.49}$P n-layer 20, having a thickness generally of 0.2 μm and electron concentration of 1 x $10^{18}$/cm$^3$, is formed on the i-layer 18. An n-Ga$_{0.51}$In$_{0.49}$P second contact layer 22 of n-type conduction, having a thickness generally of 0.13 μm and an electron concentration of 2 x $10^{18}$/cm$^3$, is formed on the n-layer 20. An n-GaAs first n-type contact layer 24 of n-type conduction, having a thickness generally of 0.06 μm and an electron concentration of 2 x $10^{18}$/cm$^3$, is formed on the second contact layer 22. An electrode layer 26 made of gold and germanium (Au/Ge), having a thickness generally of 0.2 μm, is formed so as to cover the entire back of the substrate 10. Another electrode layer 28 made of gold and germanium (Au/Ge), having a thickness generally of 0.2 μm, is formed on some portion of the first n-type contact layer 24.

A quantum-wave interference unit A having a multi-quantum layer structure with 3 pairs of a non-doped Ga$_{0.51}$In$_{0.49}$P first layer W and a non-doped Al$_{0.51}$In$_{0.49}$P second layer B is formed in the i-layer 18. FIG. 6A shows band structures of the quantum-wave interference layer A in detail. The first layer W has a thickness of 10 nm, and the second layer B has a thickness of 14 nm. A non-doped δ layer with a thickness 1.3 nm made of Al$_{0.33}$Ga$_{0.33}$In$_{0.33}$P is formed at each interface between the first layer W and the second layer B. Thicknesses of the first layer W and the second layer are determined according to Eqs. 1 and 2, respectively, on condition that no external voltage is applied thereto.

The second layers B which contact to the n-layer 20 and the n-layer 16 have thicknesses of 0.3 μm and 0.1 μm, respectively. This thickness is necessary to prevent a tunneling conduction of electrons from the n-layer 16 and the n-layer 20 to the first layer W. And the substrate 10 has a diameter of 2.0 inches and the normal direction of its main surface is offset toward the [011] axis by 15 degree from the (100) plane.

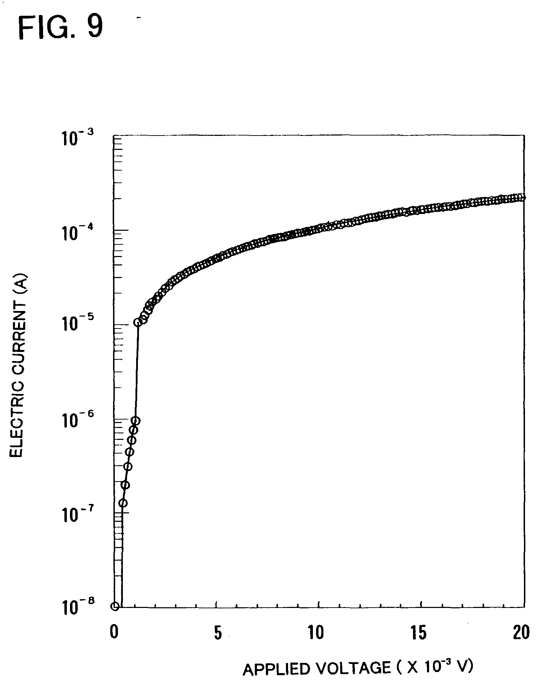

V-I characteristic was obtained by applying a voltage to the nin semiconductor device. As shown in FIG. 9, when the applying voltage is about 0.9 mV, the electric current rises abruptly, from $10^{-8}$ to $10^{-5}$, or in the range of 3 orders with a step function. It seems that this phenomena is because a wavelength of electrons which flow into a quantum-wave interference layer becomes the double of the thickness of each layer when an external voltage reaches this value. A result of satisfying a high conductive transmission condition seems to bring electric current to flow abruptly. Further, when an external voltage is more increased, a kinetic energy of electrons which flow into the quantum-wave interference layer become larger. And because the wavelength of the quantum-wave becomes smaller than the double of the thickness of each layer, high transmission condition is not satisfied and a flow rate of current decrease. The present inventor thought that the V-I characteristic shown in FIG. 9 was occurred because of such a reason described above.

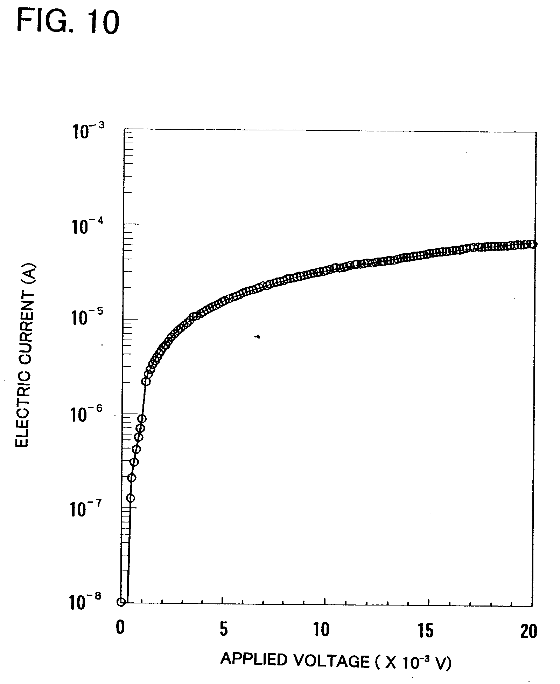

As a comparative example, a semiconductor device 200 having 6 pairs of a first layer W and a second layer B was manufactured. The first layer W and the second layer B have thicknesses of 5 nm and 7 nm, both are half as large as those of the first layer W and the second layer B of the semiconductor device 100. V-I characteristics of the semiconductor device 200 is shown in FIG. 10. Compared with the device shown in the embodiments described above, a gradient of the electric current increment is smaller, and a flowing current amount is also smaller from 1 order to 2 orders. Besides, it has been confirmed by the present inventor that in condition that layers have thicknesses as in the device 200, the quantum-well interference layer functions as a reflection layer. Accordingly, when a forward voltage increases, the electrical current which has been stopped seems to flow abruptly at the voltage that the reflection condition was not satisfied. But it is proved that the current amount is smaller by 1/100 than the current amount when the thickness of each layer is set one half of the quantum-wave wavelength as in the present embodiments. In short, a conductivity or a mobility of the device 100 of the present invention which is 100 times as large as that of the device 200. This shows that by forming the quantum-wave interference layer as described above in a transistor and by applying the range of its I-V characteristic which varies sharply, a transistor having a larger amplification factor than that of a conventional transistor can be obtained.

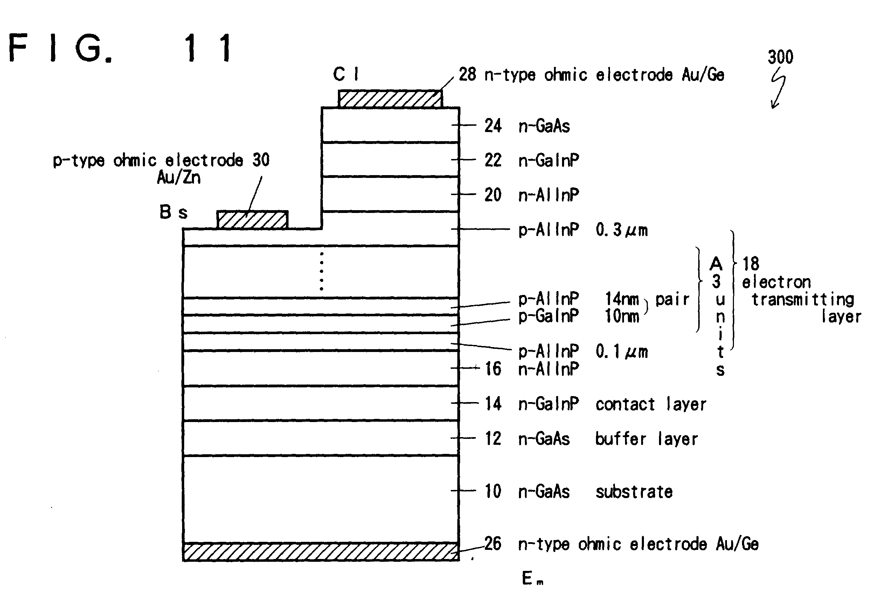

Then a transistor 300 was manufactured as shown in FIG. 11. The transistor 300 is an npn junction structure bipolar transistor, having almost the same structure as that of the device 100. A quantum-wave interference layer (electron transmission layer) A is constituted by a quantum-well (QW) structure having 3 pairs of a first layer W and a second layer B. The first layer W and the second layer B are made of p-doped $Ga_{0.51}In_{0.49}P$ and p-doped $Al_{0.51}In_{0.49}P$, respectively, and have a thickness of 10 nm and 14 nm, respectively. To make the figure simpler, $\delta$ layers are not shown in FIG. 11. The layers from a substrate 10 to a first n-type contact layer 24 which have almost the same structure as the layers from the substrate 10 to the first n-type contact layer 24 of the device 100 are formed. A portion of the n-type first contact layer 24, an n-type second contact layer 22, and an n-layer 20 are etched. Then electrodes 28 and 30 are formed on a portion of an upper surface of the n-type first contact layer 24 and on a portion of the top layer of the quantum-wave interference layer A exposed by etching, respectively. The electrodes 26, 30 and 28 of the transistor 300 are an emitter electrode, a base electrode, and a collector electrode, respectively. By using a grounded-emitter, the transistor provides an improved amplification factor compared with a transistor having a conventional structure.

Similarly, by forming a hole transmission layer described in an n-layer of a bipolar transistor having a pnp junction structure, the amplification factor can be excellently improved compared with a conventional transistor. Further, in addition to an electron or hole transmitting layer, by forming an electron reflecting layer in a base region or an emitter region and forming a hole reflecting layer in an emitter region or a base region in a transistor having an npn junction structure, and by forming a hole reflecting layer in a base region or an emitter region and forming an electron reflecting layer in an emitter region or a base region in a transistor having a pnp junction structure, the amplification factor can be improved more sharply compared with the transistor with only electron or hole transmitting layer.

Example 2

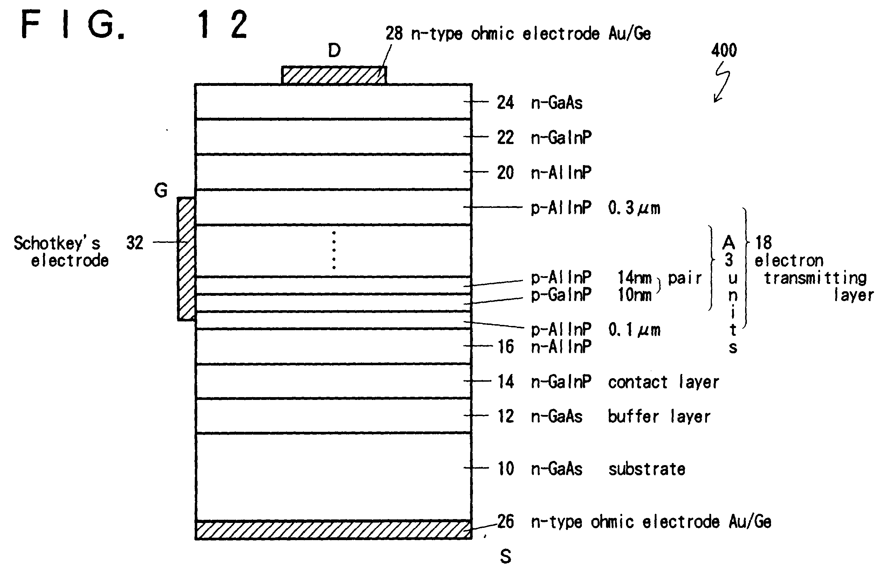

FIG. 12 shows a field effect transistor 400 used in the present embodiment. The field effect transistor 400 has the same pn junction structure as in Example 1, which is called an npn junction structure having a quantum-wave interference layer (electron transmitting layer) in the p-layer. The quantum-wave interference layer (electron transmission layer) A is constituted by a quantum-well (QW) structure having 3 pairs of a first layer W and a second layer B. The first layer W and the second layer B are made of p-doped $Ga_{0.51}In_{0.49}P$ and p-doped $Al_{0.51}In_{0.49}P$, respectively, and have a thickness of 10 nm and 14 nm, respectively. The transistor 400 is a MESFET which has a source region named S and a drain region named D both functioning as n-layers. A gate (G) electrode is formed on the electron transmitting layer 18, and forms channel in the electron transmission layer A by an applied voltage. Electric current does not flow in the region sandwiched by the source (S) and the drain (D) of the transistor 400 until the external voltage applied to the gate (G) exceeds an energy when injected electrons transmit the quantum-wave interference layer (electron transmitting layer) A. Accordingly, an efficiency of the device as a MESFET can be improved.

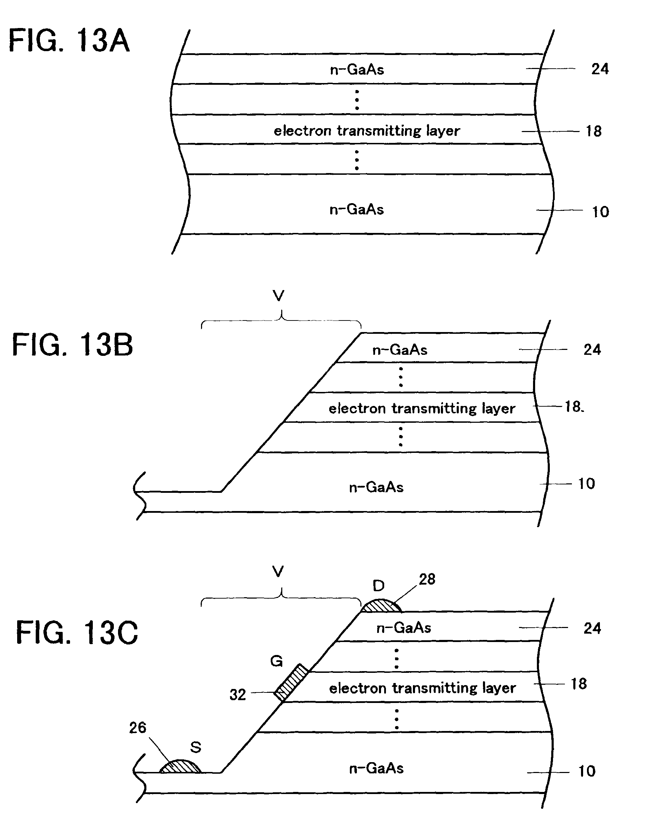

The method for manufacturing the field effect transistor 400 is shown by FIGS. 13A to 13C. FIG. 13A shows the structure of the transistor 400. Then, as shown in FIG. 13B, a declined plane V was formed by etching a portion of a substrate 10 to an n-type contact layer 24. A Schottky electrode 32 made of gold (Au) was formed at an exposed portion of the electron transmitting layer 18 on the declined plane V, and electrodes 26 and 28 are formed at a source (S) and a drain (D), respectively, as shown in FIG. 13C.

Similarly, by forming a hole transmitting layer in n-layer of pnp field effect transistor having a source and a drain regions of p-type conduction, the amplification factor can be improved sharply compared with a conventional transistor.

Example 3

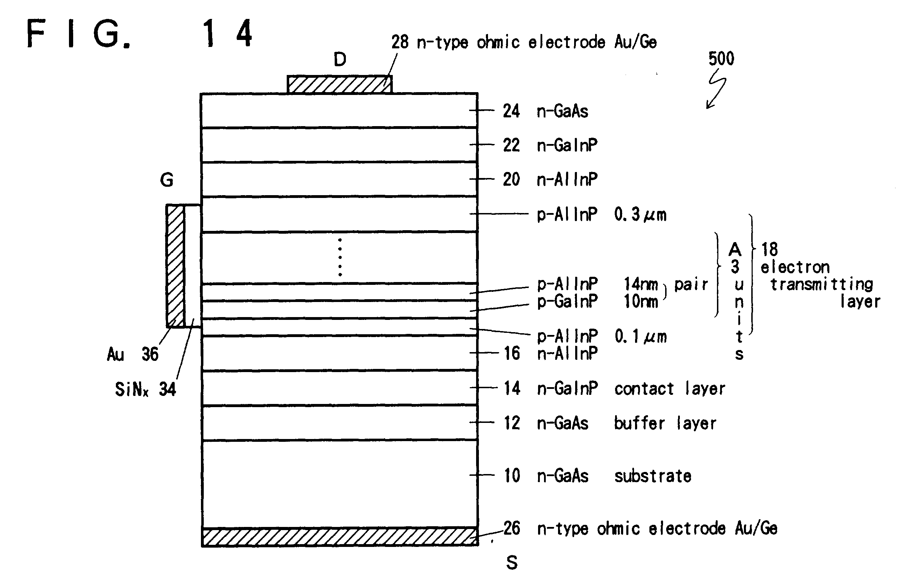

FIG. 14 shows a field effect transistor 500 used in the present embodiment. The field effect transistor 500 has the same pn junction structure as in Example 1, which is called an npn junction structure having a quantum-wave interference layer (electron transmitting layer) in the p-layer. The quantum-wave interference layer (electron transmission layer) A is constituted by a quantum-well (QW) structure having 3 pairs of a first layer W and a second layer B. The first layer W and the second layer B are made of p-doped $Ga_{0.51}In_{0.49}P$ and p-doped $Al_{0.51}In_{0.49}P$, respectively, and have a thickness of 10 nm and 14 nm, respectively. The transistor 500 is a MOSFET which has a source region named S and a drain region named D both functioning as n-layers. Electric current does not flow in the region sandwiched by the source (S) and the drain (D) of the transistor 500 until the external voltage applied to a gate (G) exceeds a certain threshold. Accordingly, an efficiency of the device as a MOSFET can be improved. The MOSFET has the same structure as that of the MESFET shown in FIG. 13, in which a metal layer 36 made of gold (Au) and an insulation layer 34 made of silicon nitride (SiN) are formed instead of the Schottky electrode 32.

In the present invention, embodiments of devices with δ layers are shown as Examples 1-3. Band gap energy at a potential interface varies sharply and interference effect of quantum-wave (i.e., high transmission) is more improved by δ layers. Alternatively, a multi-quantum well (MQW) structure without a δ layer can be applied to a device although its effect will be lowered.

Further, in Examples 1-3, the quantum-wave interference layer and the δ layer was made of ternary compounds including $Ga_{0.51}In_{0.49}P/Al_{0.51}In_{0.49}P$ and quaternary compounds including $Al_{0.33}Ga_{0.33}In_{0.33}P$, respectively. Alternatively, the quantum-wave interference layer and a δ layer can be made of quaternary compounds such as $Al_xGa_yIn_{1-x-y}P$ or $Al_xGa_yIn_{1-x-y}As$, selecting arbitrary composition ratio within the range of $0 \leqq x \leqq 1$, $0 \leqq y \leqq 1$, and $0 \leqq x+y \leqq 1$.

As another alternative, the quantum-wave interference layer can be made of multi-junction of hetero-material such as group III-V compound semiconductor, group II-VI compound semiconductors, Si and Ge, and hetero-semiconductor. The desirable compositions are as follows. Each combinations is represented by a composition of a layer having a wide band width / a layer having a narrow band width // a substrate. And x and y are arbitrary values wherein $0 \leqq x \leqq 1$ and $0 \leqq y \leqq 1$, as long as they are not specified.

〈1〉 $Al_xIn_{1-x}P$ / $Ga_yIn_{1-y}P$ / / GaAs
〈2〉 $Al_xGa_{1-x}As$ / GaAs / / GaAs
〈3〉 $Ga_xIn_{1-x}P$ / InP / / InP
〈4〉 $Ga_xIn_{1-x}P$ / $Ga_xIn_{1-x}As$ // GaAs
〈5〉 AlAs / $Al_xGa_{1-x}As$ // GaAs ($0.8 \leqq x \leqq 0.9$)
〈6〉 InP / $Ga_xIn_{1-x}As_yP_{1-y}$ / / GaAs
〈7〉 Si / $SiGe_x$ // arbitrary material ($0.1 \leqq x \leqq 0.3$)
〈8〉 Si / $SiGe_xC_y$ // arbitrary material ($0.1 \leqq x \leqq 0.3$, $0 < y \leqq 0.1$)
〈9〉 $Al_{x1}Ga_{y1}In_{1-x1-y1}N$ / $Al_{x2}Ga_{y2}In_{1-x2-y2}N$ / / Si, SiC, GaN, or sapphire ($0 \leqq x_1, x_2, y_1, y_2, x_1+y_1, x_2+y_2 \leqq 1$)

While the invention has been described in connection with what are presently considered to be the most practical and preferred embodiments, it is to be understood that the invention is not to be limited to the disclosed embodiments, but on the contrary, the description is intended to cover various modifications and equivalent arrangements included within the spirit and scope of the appended claims. The present document claims the benefit of Japanese priority document, filed in Japan on December 16, 1998, the entire contents of which is incorporated herein by reference.

Obviously, numerous modifications and variations of the present invention are possible in light of the above teachings. It is therefore to be understood that within the scope of the appended claims, the invention may be practiced otherwise than as specifically described herein.

A transistor having an electron quantum-wave interference layer with plural periods of a pair of a first layer W and a second layer B in a p-layer of an npn junction structure. The second layer B has wider band gap than the first layer W. Each thicknesses of the first layer W and the second layer B is determined by multiplying by an even number one fourth of quantum-wave wavelength of carriers in each of the first layer W and the second layer B, the carriers existing around the lowest energy level of the second layer B. The quantum-wave interference layer functions as an electron transmitting layer, and enables to lower a dynamic resistance of the transistor notably. A performance characteristics of a MESFET of an npn junction structure, having the electron transmitting layer is improved compared with a MESFET without an electrode transmitting layer. Similarly, a transistor having a hole reflecting layer, which has an improved performance characteristics, can be obtained. Forming a hole reflecting layer can be applied to a bipolar transistor or a MOSFET.

**Claims**

1. A transistor which includes a quantum-wave interference layer having plural periods of a pair of a first layer and a second layer, said second layer having wider band gap than said first layer, and said quantum-wave interference layer being formed in a base region or a channel region; and characterized in that each thickness of said first and said second layers is determined by multiplying by even number one fourth of wavelength of quantum-wave of injected minority carriers in each of said first and said second layers.

2. A transistor according to claim 1, which includes a δ layer for sharply varying energy band, being formed between said first and said second layers, and thickness of said δ layer being substantially thinner than the thickness of said first and said second layers.

3. A transistor according to claim 1 and 2, said injected minority carriers being existing around the lowest energy level of said second layer.

4. A transistor according to claim 1 and 2, characterized in that said wavelength $\lambda_W$ in said first layer is determined by a formula $\lambda_W = h/[2m_W(E+V)]^{1/2}$, said wavelength $\lambda_B$ in said second layer is determined by a formula $\lambda_B = h/(2m_B E)^{1/2}$, said thickness of said first layer $D_W$ is determined by a formula $D_W = n_W \lambda_W/4$, and said thickness of said second layer $D_B$ is determined by a formula $D_B = n_B \lambda_B/4$, where h, $m_W$, $m_B$, E, V, and $n_W$ and $n_B$ represent a Plank's constant, effective mass of said carrier in said first layer, effective mass of said carrier in said second layer, kinetic energy of carriers injected into said second layer, potential energy of said second layer to said first layer, and even number, respectively.

5. A transistor having a quantum-wave interference layer with plural periods of a pair of a first layer and a second layer, said second layer having a wider band gap than said first layer, and said quantum-wave interference layer being formed in a base region or a channel region, which includes a plurality of partial quantum-wave interference layer $I_k$ with $T_k$ periods of a pair of said first layer and said second layer being displaced in series by varying k as 1, 2, ...; and characterized in that index k of said plurality of said partial quantum-wave interference layers corresponds to index k of kinetic energy level $E_k$ and said first and second layers have thicknesses of $n_{Wk}\lambda_{Wk}/4$ and $n_{Bk}\lambda_{Bk}/4$, respectively, where $E_k+V$ and $E_k$, $\lambda_{Wk}$ and $\lambda_{Bk}$, $n_{Wk}$ and $n_{Bk}$ represent kinetic energy level of minority carriers injected into respective said first layer and said second layer, quantum-wave wavelength of carriers flowing into respective said first layer and said second layer, and even numbers, respectively, and $\lambda_{Wk}$ and $\lambda_{Bk}$ are determined by functions of $E_k+V$ and $E_k$, respectively.

6. A transistor having a quantum-wave interference layer with plural periods of a pair of a first layer and a second layer, said second layer having a wider band gap than said first layer, and said quantum-wave interference layer being formed in a base region or a channel region, which includes a plurality of partial quantum-wave interference layer, each of said partial quantum-wave interference layer having serial pairs of said first layer and said second layer with serial pairs of thicknesses of $(n_{W1}\lambda_{W1}/4, n_{B1}\lambda_{B1}/4)$, ..., $(n_{Wk}\lambda_{Wk}/4, n_{Bk}\lambda_{Bk}/4)$, ..., $(n_{Wj}\lambda_{Wj}/4, n_{Bj}\lambda_{Bj}/4)$ where $E_k+V$ and $E_k$, $\lambda_{Wk}$ and $\lambda_{Bk}$, $n_{Wk}$ and $n_{Bk}$ represent kinetic energy level of minority carriers injected into respective said first layer and said second layer, quantum-wave wavelength of carriers injected into respective said first layer and said second layer, and even numbers, respectively, and $\lambda_{Wk}$ and $\lambda_{Bk}$ are determined by functions of $E_k+V$ and $E_k$, respectively.

7. A transistor according to claim 1, 5, and 6, characterized in that thickness of each of said quantum-wave interference layers are determined according to a quantum-wave wavelength of carrier which conducts at a certain threshold of applied electric field.

8. A transistor according to claim 1, 5, and 6, which includes a δ layer for sharply varying energy band, being formed between said first and said second layers, and thickness of said δ layer being substantially thinner than the thickness of said first and second layers.

9. A transistor according to claim 1, 5, and 6, characterized in that a quantum-wave incident plane in said quantum-wave interference layer is said second layer having enough thickness to prevent conduction of minority carriers by a tunneling effect.

10. A transistor according to claim 1, 5, and 6, characterized in that said quantum-wave interference layer is formed in said base region, and said transistor is a bipolar transistor.

**11.** A transistor according to claim 1, 5, and 6, characterized in that said quantum-wave interference layer is formed in said channel region, and said transistor is a field effect transistor.

# F I G. 1

# F I G. 2

Energy Ratio X

FIG. 3A

FIG. 3B

FIG. 3C

FIG. 3D

FIG. 3E

FIG. 3F

FIG. 3G

FIG. 3H

EP 1 011 147 A2

FIG. 4

# F I G. 5

FIG. 6A

FIG. 6B

FIG. 6C

FIG. 6D

FIG. 7A

Bo | W | B | W | B | W | B

FIG. 7B

Bo | W | B | W | B | W | B

FIG. 7C

Bo | W | B | W | B | W | B

FIG. 7D

Bo | W | B | W | B | W | B

EP 1 011 147 A2

# F I G. 8

100

28 n-type ohmic electrode Au/Ge

— 24  n-GaAs

— 22  n-GaInP

— 20  n-AlInP

— i-AlInP  0.3 μm

i-AlInP  14nm ⎞ pair
i-GaInP  10nm ⎠

A
3
u
n
i
t
s

18
electron
transmitting
layer

— i-AlInP  0.1 μm

— 16  n-AlInP

— 14  n-GaInP  contact layer

— 12  n-GaAs  buffer layer

— 10  n-GaAs  substrate

— 26  n-type ohmic electrode Au/Ge

## FIG. 9

# FIG. 10

# F I G. 1 1

300

C I — 28 n-type ohmic electrode Au/Ge

— 24 n-GaAs

p-type ohmic electrode 30
Au/Zn

— 22 n-GaInP

— 20 n-AlInP

B s

— p-AlInP 0.3 $\mu$m

$\left.\begin{array}{c}\\\\\\\end{array}\right\}$ A 3 units $\left.\begin{array}{c}\\\\\\\end{array}\right\}$ 18 electron transmitting layer

— p-AlInP 14nm $\left.\begin{array}{c}\\\\\end{array}\right\}$ pair
— p-GaInP 10nm

— p-AlInP 0.1 $\mu$m
— 16 n-AlInP

— 14 n-GaInP contact layer

— 12 n-GaAs buffer layer

— 10 n-GaAs substrate

— 26 n-type ohmic electrode Au/Ge

E $_m$

EP 1 011 147 A2

# F I G. 1 2

D

EP 1 011 147 A2

28 n-type ohmic electrode Au/Ge

400

— 24 n-GaAs

— 22 n-GaInP

— 20 n-AlInP

— p-AlInP 0.3 μm

G

Schotkey's electrode 32 —

— p-AlInP 14nm ) pair
— p-GaInP 10nm )

A 3 units } 18 electron transmitting layer

— p-AlInP 0.1 μm

— 16 n-AlInP

— 14 n-GaInP contact layer

— 12 n-GaAs buffer layer

— 10 n-GaAs substrate

— 26 n-type ohmic electrode Au/Ge

S

FIG. 13A

n-GaAs — 24

⋮

electron transmitting layer — 18

⋮

n-GaAs — 10

FIG. 13B

V

n-GaAs — 24

⋮

electron transmitting layer — 18.

⋮

n-GaAs — 10

FIG. 13C

V

D 28

n-GaAs — 24

⋮

G

32 — electron transmitting layer — 18

⋮

26

S

n-GaAs — 10

# F I G. 1 4

EP 1 011 147 A2

500

D — 28 n-type ohmic electrode Au/Ge

— 24 n-GaAs

— 22 n-GaInP

— 20 n-AlInP

G

— p-AlInP 0.3 μm

⎱ 18 electron transmitting layer
A 3 units

— p-AlInP 14nm ⎱ pair
— p-GaInP 10nm ⎰

— p-AlInP 0.1 μm

— 16 n-AlInP

Au 36

SiNx 34

— 14 n-GaInP contact layer

— 12 n-GaAs buffer layer

— 10 n-GaAs substrate

— 26 n-type ohmic electrode Au/Ge

S